(19) **Europäisches Patentamt**
**European Patent Office**
**Office européen des brevets**

(11) **EP 3 467 462 B1**

(12) **EUROPEAN PATENT SPECIFICATION**

(45) Date of publication and mention
of the grant of the patent:
**06.09.2023 Bulletin 2023/36**

(21) Application number: **17810237.2**

(22) Date of filing: **02.06.2017**

(51) International Patent Classification (IPC):
**G01M 17/04** $^{(2006.01)}$ **G01L 1/16** $^{(2006.01)}$

(52) Cooperative Patent Classification (CPC):
**G01L 1/162**

(86) International application number:
**PCT/JP2017/020723**

(87) International publication number:
**WO 2017/213059 (14.12.2017 Gazette 2017/50)**

(54) **WIDE-RANGE LOAD SENSOR USING QUARTZ RESONATOR**

WEITREICHENDER LASTSENSOR MIT QUARZRESONATOR

CAPTEUR DE CHARGE À GAMME ÉTENDUE UTILISANT UN RÉSONATEUR À QUARTZ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.06.2016 JP 2016113022**

(43) Date of publication of application:
**10.04.2019 Bulletin 2019/15**

(73) Proprietor: **National University Corporation Nagoya University**
**Nagoya-shi, Aichi 464-8601 (JP)**

(72) Inventors:
• **ARAI Fumihito**
**Nagoya-shi**
**Aichi 464-8601 (JP)**

• **MUROZAKI Yuichi**
**Nagoya-shi**
**Aichi 464-8601 (JP)**
• **SAKUMA Shinya**
**Nagoya-shi**
**Aichi 464-8601 (JP)**

(74) Representative: **Kuhnen & Wacker**
**Patent- und Rechtsanwaltsbüro PartG mbB**
**Prinz-Ludwig-Straße 40A**
**85354 Freising (DE)**

(56) References cited:
**JP-A- S5 640 727**    **JP-A- H01 109 228**
**JP-A- 2002 365 123**    **JP-A- 2011 058 944**
**JP-A- 2015 025 796**    **US-A- 3 479 536**
**US-A1- 2002 078 762**    **US-A1- 2003 000 317**

## Description

TECHNICAL FIELD

The present invention relates to a load sensor using a quartz crystal resonator and, more particularly, to a technique of widening a measurement range of the load sensor.

BACKGROUND ART

A load sensor using a quartz crystal resonator (QCR: Quartz Crystal Resonator) is known. For example, this corresponds to a load sensor described in Patent Document 1. According to the description regarding this load sensor using a quartz crystal resonator, a load sensor capable of highly-sensitive, highly-precise, and long-term stable measurement can be implemented based on the fact that when a load is applied to the quartz crystal resonator formed into a sheet shape, the oscillating frequency thereof varies precisely in proportion to the applied load.

In the load sensor using the quartz crystal resonator, the quartz crystal resonator is formed into an elongated shape and plate shape and, a load is applied to the longitudinal direction. The load sensor proposed in Japanese Patent Publication No. 2015-025796 includes a quartz crystal resonator and a holder capable of applying a load while holding the quartz crystal resonator. Regarding this holder, it is considered that while both ends in the longitudinal direction of the quartz crystal resonator are held, a load is input from one end thereof with the other end fixed so as to apply the load to the quartz crystal resonator.

From patent US 3 479 539 A it is known a force transducer comprising a thin, elongated, piezoelectric, vibratory beam member mounted to receive compressive and tensile forces along its length and which affect its natural frequency of vibration. To drive the beam, longitudinally spaced, oppositely directed, alternating electric fields are impressed across the beam along the thickness thereof and these fields are produced by pairs of electrodes placed on opposite sides of the beam and electrically excited to produce oppositely directed electric fields through the beam. The beam is oriented crystallographically so that such fields cause oppositely directed body shear strains, causing bending of the beam.

From US patent application US 2002/0078762 A1 it is known a load sensor measuring a load by a change in oscillation frequency of a crystal (quartz) blank due to stress sensibility against thereof when a load is applied to opposing outer circumferential portions of the crystal blank. In the sensor, the crystal blank is formed in a shape such that when the load is applied, any mechanical deformation in a direction perpendicular to the plane of the blank is prevented. The crystal blank is constituted by two regions, a vibrating portion having a relatively small thickness and a protective frame portion having a relatively large thickness.

SUMMARY OF THE INVENTION

Problem to Be Solved by the Invention

However, a plate-shaped quartz crystal resonator formed into a sheet shape and an elongated shape is characterized by weakness against bending stress attributable to the shape thereof, and when the quartz crystal resonator is used as a load sensor, a technique is still required for stably holding the quartz crystal resonator. In the technique described in Patent Document 1, to avoid buckling of the quartz crystal resonator when a large load is applied, for example, a configuration is required for distributing the load applied to one load sensor. Additionally, in this case, although a detection range of the load sensor can be widened, a problem of reduced resolution occurs.

The present invention was conceived in view of the situations and it is therefore an object of the present invention to provide a load sensor using a quartz crystal resonator having a widened detection range while maintaining a resolution by preventing buckling of the quartz crystal resonator.

Solution to Problem

To achieve the above object, a first aspect of the present invention provides a load sensor (a) detecting a magnitude of an external load applied in a direction parallel to a sheet shape of a sheet-shaped quartz crystal resonator according to claim 1.

Advantageous Effects of Invention

As a result, even if a bending stress is generated in the quartz crystal resonator in a case where an external load is applied in a direction parallel to a plane direction of the sheet shape of the sheet-shaped quartz crystal resonator, the quartz crystal resonator layer is restrained from deforming toward both side of the sheet shape by the 1 pair of holding layers, so that buckling of the quartz crystal resonator layer can be prevented. Therefore, the thickness of the sheet-shaped quartz crystal resonator can be reduced, and the measurement range can be widened. Further, the holding layers and the quartz crystal resonator layer have common thermal expansion characterstics regardless of an environmental temperature at which the load sensor is placed, so that it is not necessary to give consideration to a difference in expansion amount of these layers in the measurement result depending on the environmental temperature.

Preferably, the holding layers are bonded to the quartz crystal resonator layer via adhesive layers. Therefore, the quartz crystal resonator layer and the holding layers are bonded by the adhesive layers, so that the buckling of the quartz crystal resonator layer can be suppressed.

Preferably, the load sensor recited in the second aspect of the invention, wherein the adhesive layers have at least an elongated shape extending in an application direction of the external load. This can suitably prevent deformation of the quartz crystal resonator layer in a bending direction, which is likely to occur when the external load is applied, and the buckling can be suppressed.

Preferably, the load sensor recited in the second or third aspect of the invention, wherein each of the adhesive layers bonds the respective one of holding layers and the quartz crystal resonator layer through atomic diffusion bonding. Therefore, the holding layers and the quartz crystal resonator layer are suitably bonded by atomic diffusion bonding of the adhesive layers respectively disposed on each of the holding layers and the quartz crystal resonator layer.

Preferably, the load sensor recited in the first aspect of the invention, wherein the holding layers are made of quartz crystal material, and wherein the holding layers and the quartz crystal resonator layer are coupled by direct bonding. Therefore, the quartz crystal resonator layer and the holding layers are coupled by the direct bonding and can perform like an integrated crystal, so that the buckling of the quartz crystal resonator layer can be suppressed.

BRIEF DESCRIPTION OF DRAWINGS

FIGS. 1A to 1C are views for explaining an example of a load sensor to which the present invention is applied, including FIG. 1A of a perspective view, FIG. 1B of a view for explaining individual constituent members, and FIG. 1C of a cross-sectional view in FIG. 1A.

Fig. 2 is a process chart for explaining a manufacturing process of the load sensor of this example.

FIGS. 3A to 3H are views for explaining changes in cross sections of a quartz crystal wafer and a quartz crystal substrate generated by the processes of Fig. 2.

Fig. 4 is a photograph showing an appearance of the load sensor of this example.

Fig. 5 is a diagram for explaining a result of a fracture test performed on a test piece of a quartz crystal resonator.

Fig. 6 is a view for explaining an analysis result of a stress in the load sensor of this example.

Fig. 7 is a diagram for explaining a general configuration of a load measurement system including the load sensor of this example.

Fig. 8 is a diagram showing a result acquired from a load application experiment on the load sensor of this example.

Fig. 9 is a diagram showing a result acquired from an experiment for evaluating an output stability of the load sensor of this example.

Fig. 10 is a diagram of comparison of the characteristics of the load sensor of this example with conventional load sensors.

Fig. 11 is a diagram for explaining a measuring device 60 for simultaneously measuring a body weight and a pulse wave of a subject by using the load sensor 10 of this example.

FIGS. 12 are diagrams for explaining an example of output signals in the measuring apparatus in Fig. 11, showing FIG. 12A of the output signals as it is and FIGS. 1B of the signals after passing through a band pass filter.

FIGS. 13A and 13B are diagrams for explaining a configuration of a load sensor according to another example of the present invention. FIG. 13A is a perspective view of the load sensor, and FIG. 13B is a cross-sectional view taken along XIIIB-XIIIB of Fig. 13(a).

FIGS. 14A and 14B are diagrams for explaining a configuration of a load sensor according to yet another example of the present invention. FIG. 14A is a perspective view of the load sensor, and FIG. 14B is a cross-sectional view taken along XIVB-XIVB of FIG. 14A.

FIGS. 15A and 15B are diagrams for explaining other forms of the load sensor of FIGS. 1A to 1C and explaining other shapes of an adhesive layer.

MODES FOR CARRYING OUT THE INVENTION

An example of the present invention will be described in detail with reference to the drawings. In the following example, the figures are simplified or deformed as appropriate and portions are not necessarily precisely drawn in terms of dimension ratio, shape, etc.

First Example

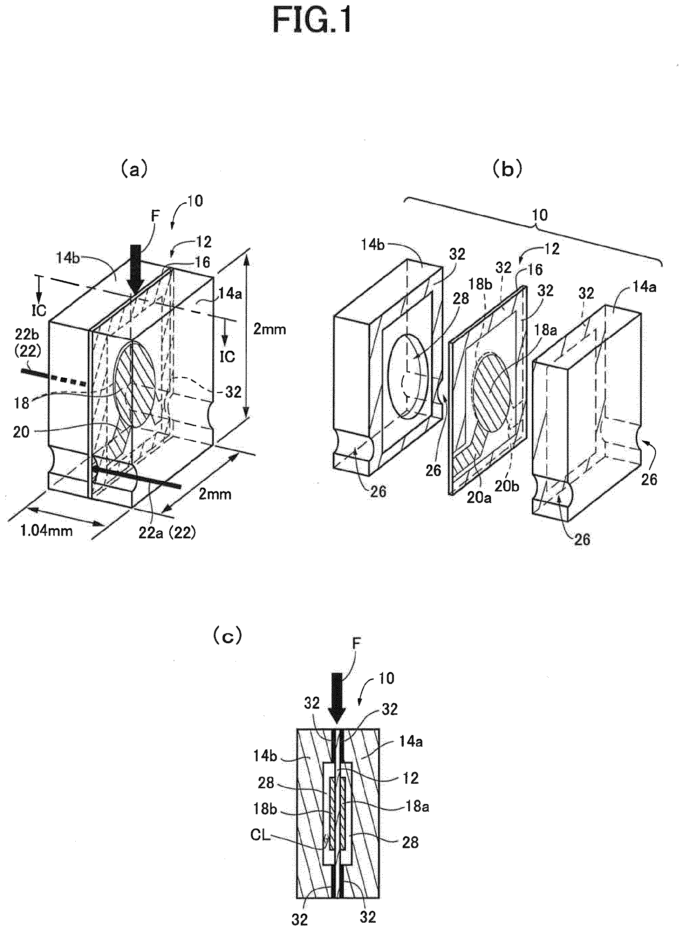

FIGS. 1A to 1C are schematic diagrams for explaining a configuration of a load sensor 10 that is an example of the present invention. FIG. 1A is a perspective view of the load sensor 10. The load sensor 10 is configured to include a substantially sheet-shaped quartz crystal resonator layer 12 and a pair of holding layers 14a and 14b disposed to sandwich the substantially sheet-shaped quartz crystal resonator layer 12 in a thickness direction. In the following description, the holding layers 14a and 14b are collectively referred to simply as holding layers 14 if the layers 14a and 14b are not distinguished. As shown in FIG. 1A, in this example, both the quartz crystal resonator layer 12 and the holding layers 14 have a substantially square shape of 2 [mm] in length and 2 [mm] in width. The quartz crystal resonator layer 12 has a thickness of 41.7 [μm], and the holding layer 14 has a thickness of 500 [μm].

FIG. 1B is a view for explaining a configuration of the quartz crystal resonator layer 12 and the pair of the holding layers 14, each constituting the load sensor 10 shown in FIG. 1A, as of before being overlapped with each other. The quartz crystal resonator layer 12 is configured to include a sheet-shaped quartz crystal resonator 16 and a pair of electrodes 18a, 18b disposed on a pair of surfaces opposite to each other in a plate thickness direction of the quartz crystal resonator 16. In the following description, the electrodes 18a and 18b are collectively referred to simply as electrodes 18 if the electrodes 18a and 18b are not distinguished. The electrodes 18a and 18b are provided with electric wires 20a and 20b, respectively, for connecting the electrodes 18a, 18b to an oscillation circuit 50 described later.

For example, an AT-cut quartz crystal excellent in temperature stability is used for the quartz crystal resonator 16. An AT-cut quartz crystal resonator generates thickness-shear vibration at an electrode portion according to an applied voltage from the outside so that an output can be obtained in the form of an electric periodic signal at a resonance frequency precisely proportional to an external force. In a substantially central portion on a plane of the quartz crystal resonator 16, the pair of the electrodes 18a, 18b opposed to each other in a thickness direction D is each disposed in a substantially circular shape. The electrodes 18a, 18b are made by sputtering as described later. The respective electric wires 20a, 20b extend on the plane of the quartz crystal resonator 16 from the electrodes 18a, 18b in diagonal directions oppositely to each other to near an end portion of the quartz crystal resonator 16. The electric wires 20a, 20b are provided in the form of a pattern, for example. The electric wires 20a, 20b are electrically connected to electric wires 22a, 22b disposed outside the load sensor 10 at the end portion of the quartz crystal resonator 16. In the following description, the electric wires 22a and 22b are collectively referred to simply as electric wires 22 if the electric wires 22a and 22b are not distinguished.

The quartz crystal resonator 16 having such configuration is formed by, for example, forming electrodes on both surfaces of a sheet-shaped AT-cut quartz crystal wafer by using a Lift-off process and dividing the wafer by dicing. Specifically, a sacrificial layer is first patterned on an AT-cut quartz crystal wafer, and electrodes are then formed by sputtering of Cr and Au, which is followed by removal of the sacrificial layer. This series of processes is performed on both sides of the wafer to pattern the electrodes, and after completion of the electrodes 18, the wafer is cut with a dicing saw to form multiple quartz crystal resonators 16.

To obtain the quartz crystal resonator 16 having a small thickness, etching of quartz crystal is conceivable; however, it is desirable that oscillation characteristics of the quartz crystal resonator 16 are not affected by reduction in flatness resulting from surface roughness generated due to the etching. Specifically, for example, in this example, both surfaces of the quartz crystal resonator 16 are mirror-polished before use.

Regarding the relationship between the thickness of the quartz crystal resonator 16 and the size of the electrodes 18, it is considered that the optimum diameter of the electrodes 18 is about 15 to 20 times as large as the thickness D of the quartz crystal resonator 16. Additionally, it is considered that an outer shape, i.e., a size in a plane direction, of quartz crystal needs to be sufficiently large relative to the diameter of the electrode 18. Therefore, the thickness of the quartz crystal resonator 16 is set to 41.7 [$\mu$m], while the vertical and horizontal sizes are set to 2 [mm].

The electric wires 20 are copper wires for wiring coupled and electrically connected to the respective electrodes 18 on the pattern of the electrodes 18 extending to near the end portion on the plane of the quartz crystal resonator 16. The electric wires 22 are wires for connecting the electric wires 20 and the oscillation circuit 50 described later directly or via a relay board etc. The electric wires 22 are copper wires for wiring having a diameter larger than the electric wires 20 and are wired along groove portions 26 disposed in the holding layers 14 described later, for example.

In this example, the holding layers 14 are made of bulk (block-shaped) quartz crystal. Therefore, the holding layers 14 and the quartz crystal resonator layer 12 are made of materials having substantially equivalent rates of thermal expansion. This reduces output variation resulting from thermal stress due to a difference in thermal expansion coefficient between the holding layers 14 and the quartz crystal resonator layer 12, which eliminates the need for considering an influence of the thermal stress on a measurement result for each environmental temperature at which the load sensor 10 is used.

The holding layers 14 have a sufficient thickness as compared to the quartz crystal resonator layer 12. Specifically, in this example, as described above, the thickness of the quartz crystal resonator layer 12 is 41.7 [$\mu$m], while the thickness of the holding layers 14 is 500 [$\mu$m]. The holding layers 14 are provided with concave grooves 26 extending in a thickness direction thereof at position corresponding to the electric wires 20 led out from the electrodes 18 of the quartz crystal resonator layer 12 on surfaces serving as outer circumferential surfaces of the load sensor 10 when the holding layers 14 are bonded to the quartz crystal resonator layer 12 described above, so that end portions of the electric wires 20 are exposed when the holding layers 14 and the quartz crystal resonator layer 12 are overlapped with each other. The electric wires 22 are connected to the end portions of the exposed electric wires 20. The grooves 26 have a circular arc cross section, and this is because stress concentration hardly occurs in a specific portion of the grooves 26 when a load is applied to the quartz crystal resonator layer 12.

As shown in FIG. 1C, in surfaces of the holding layers 14 to be overlapped with the quartz crystal resonator layer 12, recesses 28 are formed in portions corresponding to the electrodes 18 when the holding layers 14 are overlapped with the quartz crystal resonator layer 12. FIG. 1C is a cross-sectional view showing a cross section taken along IC-IC of FIG. 1A. The recesses 28 are disposed as holes having a circular cross section, and the size and the depth of the recesses 28 are set such that the electrodes 18 are not brought into contact with the holding layers 14, or specifically, for example, such that a clearance CL of about 10 $\mu$m is provided between the holes provided as the recesses 28 and the electrodes 18, when the holding layers 14 are overlapped with the quartz crystal resonator layer 12. By disposing the recesses 28, when the holding layers 14 are overlapped with the quartz crystal resonator layer 12, the oscillation of the quartz crystal resonator 16 is not prevented by contact therebetween. In other words, a portion of the quartz crystal resonator layer 12 facing the recesses 28 is ensured as a vibrating portion generating suitable vibration. The shape of the recesses 28 is not limited to a hole having a circular cross section as described above and may be any shape as long as the electrodes 18 are not brought into contact with the holding layers 14.

The holding layers 14 and the quartz crystal resonator layer 12 are respectively provided with adhesive layers 32 disposed on the surfaces of the layers 14 and the quartz crystal resonator layer 12 to be overlapped each other. In this example, the adhesive layer 32 is a metal thin film formed by sputtering, and specifically, in this example, the thin film is obtained by forming a film of gold (Au) after forming a film of chromium (Cr). As shown in FIG. 1B, the quartz crystal resonator layer 12 has the adhesive layers 32 disposed so as to surround the outer circumferential side of the quartz crystal resonator 16 on the plane of the quartz crystal resonator 16. To prevent contact with the electrodes 18 and the electric wires 20 disposed on the quartz crystal resonator layer 12, the adhesive layers 32 are disposed without overlapping with each of the electrodes 18 and the electric wires 20 and at a predetermined interval or more from the electrodes 18 and the electric wires 20. The adhesive layers 32 are respectively disposed on both surfaces of the quartz crystal resonator layer 12 and the surfaces of the pair of the holding layers 14 to be overlapped with the quartz crystal resonator layer 12, and the adhesive layers 32 disposed on the holding layers 14 have the same shape as the adhesive layers 32 disposed on the overlapped quartz crystal resonator layer 12 when the holding layers 14 are overlapped with the quartz crystal resonator layer 12. On the premise that insulation from the electric wires 20 is ensured, as shown in FIG. 1B, the adhesive layers 32 of the holding layers 14 may be disposed over the entire circumference on the outer circumference side of the surfaces.

For example, in a case where the holding layers 14 and the quartz crystal resonator layer 12 are bonded by the adhesive layers 32, the adhesive layers 32 are disposed in portions other than the recesses 28 on the surfaces of the holding layers 14 coming into contact with the quartz crystal resonator layer 12 and may be disposed entirely or partially on the surfaces other than the recesses 28. The position, the size, etc. of the adhesive layers 32 are determined so as not to cause buckling of the quartz crystal resonator layer 12 when a load is applied to the quartz crystal resonator layer 12 in a load measurement direction. As a result, the buckling of the quartz crystal resonator layer 12 can be suppressed.

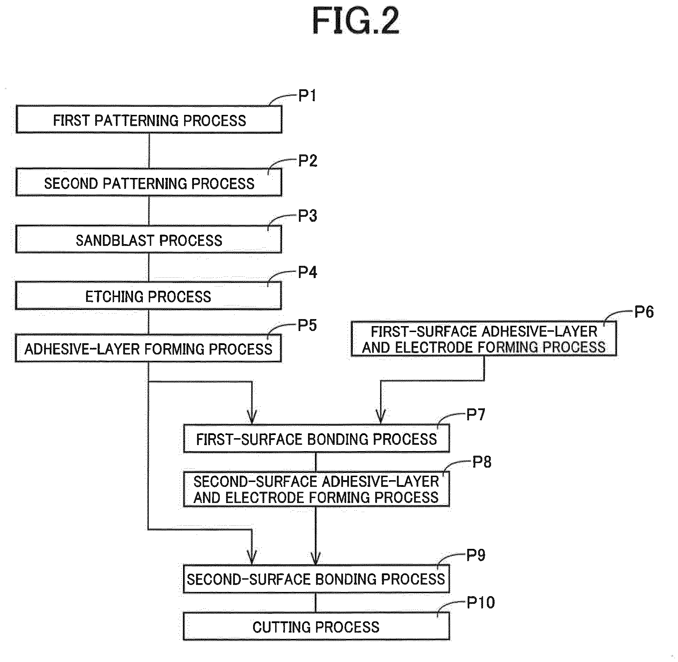

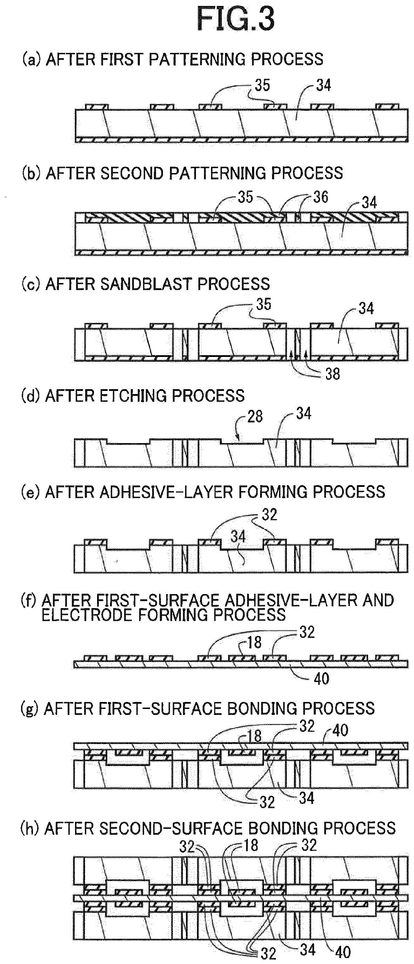

Fig. 2 is a process chart for explaining a manufacturing process of the load sensor 10 of this example, and FIGS. 3A to 3H are views showing an intermediate shape of the holding layer 14 or the quartz crystal resonator layer 12 in each process of the load sensor 10. In FIGS 3A to 3H, three the holding layers 14 and three quartz crystal resonator layers 12 are formed on a quartz crystal wafer 34 and a quartz crystal substrate 40 respectively; however, this is only an example, and the numbers thereof are not limited.

In Fig. 2, processes P1 to P5 are processes for manufacturing the holding layers 14, and P6 is a process for the quartz crystal resonator layers 12. P7 to P8 are processes for both the quartz crystal resonator layers 12 and the holding layers 14.

In a first patterning process P1, a pattern mask 35 made of a metal thin film is formed on a surface of the quartz crystal wafer 34, which has 500 [$\mu$m] thickness, to be bonded to the quartz crystal resonator layer 12. This metal thin film is, for example, a Cr/Ag thin film, i.e., a metal thin film formed by forming an overlapping Ag thin film after forming a Cr thin film on the quartz crystal wafer 34; however, the metal thin film is not limited thereto. The pattern mask 35 formed in the first patterning process P1 is used for etching performed in an etching process P4 described later and is specifically a mask for forming the recesses 28. FIGS. 3A is a view showing the quartz crystal wafer 34 in a state after this first patterning process P1 is performed. The quartz crystal wafer 34 is processed for the holding layers 14.

In a second patterning process P2, a pattern mask 36 is formed by using a photoresist on the pattern mask 35 formed in the first patterning process P1. Specifically, after the photoresist (e.g., SU-8) is applied on the pattern mask 35, exposure and local removal, i.e., patterning, are performed in a predetermined pattern to form the pattern mask 36. FIG. 3B is a view showing the quartz crystal wafer 34 in a state after the second patterning process P2 is executed to form the pattern mask 36 of the photoresist.

In a sandblast process P3, a surface of the quartz crystal wafer 34 is sandblasted by using the pattern mask 36 formed in the second patterning process P2. The sandblasting process provides cuts 38 penetrating the quartz crystal wafer 34. The cuts 38 corresponds to the grooves 26 etc. Additionally, after completion of the sandblasting, the pattern mask 36 is removed. FIG. 3C shows the quartz crystal wafer 34 in a state after the sandblasting is completed to provide the cuts 38 and the pattern mask (sheet-shaped resist) 36 is removed.

In the etching process P4, a wet etching treatment is performed by using the pattern mask 35 formed in the first patterning process P1. Specifically, only the portion exposed with the pattern mask 35 formed is removed by 10 [$\mu$m] by the wet etching treatment. In other words, execution conditions for etching, such as etchant, solution temperature, execution time, etc., are determined such that the portion is removed by 10 [$\mu$m]. Specifically, in this example, the portion exposed with the pattern mask 35 is a portion corresponding to the recess 28, and this portion is removed to form the recesses 28 having a predetermined shape. Therefore, on the surface of the holding layer 14 to be overlapped with the quartz crystal resonator layer 12, the portion to be etched is a portion facing the vibrating portion of the quartz crystal resonator 16 when overlapped with the quartz crystal resonator layer 12. After completion of the etching treatment, the pattern mask 35 is removed. FIG. 3D shows the quartz crystal wafer 34 in a state after the etching process P4 is performed to form the recesses 28 and the pattern mask 35 is removed.

In an adhesive-layer forming process P5, films of Cr and Au serving as the materials of the adhesive layer 32 are sequentially formed by using a sputtering apparatus over a stencil mask not shown fixed to the surface of the quartz crystal wafer 34 and having an opening pattern of a shape corresponding to the multiple adhesive layers 32, and the stencil mask is taken off so that the multiple adhesive layers 32 made of Cr/Au thin films having a pattern shown in FIG. 3E are respectively fixed to both surfaces of the quartz crystal wafer 34 with sputtering device. FIG. 3E shows the quartz crystal wafer 34 in a state after the adhesive-layer forming process P5 is performed.

In a first-surface adhesive-layer and electrode forming process P6, the electrodes 18 and the adhesive layers 32 are disposed on one surface of the mirror-finished quartz crystal substrate 40 having a predetermined thickness (41.7 $\mu$m, which is the thickness of the quartz crystal resonator 16 in this example) as described above. The quartz crystal substrate 40 serves as the quartz crystal resonator portion 12. The specific procedure is the same as the adhesive-layer forming process P5 in which the adhesive layer 32 is disposed on the quartz crystal wafer 34 and therefore will not be described. The electric wires 20 for connecting the electrodes 18 and the oscillation circuit 50 are also disposed in a form of pattern wire. FIG. 3F shows the quartz crystal substrate 40 in a state after the electrodes 18 and the adhesive layers 32 are disposed on one surface of the quartz crystal substrate 40 by performing the first surface adhesive-layer and electrode forming process P6.

In a first-surface bonding process P7, the quartz crystal wafer 34 and the quartz crystal substrate 40 provided with the respective adhesive layers 32 in the adhesive-layer forming process P5 and the first-surface adhesive-layer and electrode forming process P6 are overlapped such that the adhesive layers 32 face each other, and both of the adhesive layers 32 are bonded by atomic diffusion bonding. As a result, the quartz crystal wafer 34 and the quartz crystal substrate 40, in other words, the holding layer 14 and the quartz crystal resonator layer 12 are bonded. FIG. 3G is a view showing an example of bonding by the atomic diffusion bonding in the bonding process P7 between the quartz crystal wafer 34 provided with the adhesive layer 32 in the adhesive-layer forming process P5 and the quartz crystal substrate 40 having one surface provided with the electrodes 18 and the adhesive layers 32 in the first surface adhesive-layer and electrode forming process P6.

Subsequently, a second-surface adhesive-layer and electrode forming process P8 is performed. In the second-surface adhesive-layer and electrode forming process P8, the electrodes 18 and the adhesive layers 32 are disposed on the other surface of the quartz crystal substrate 40. The procedure is substantially the same as the first-surface adhesive-layer and electrode forming process P6 and therefore will not be described.

Additionally, in a second-surface bonding process P9, another quartz crystal wafer 34 provided with the adhesive layers 32 in the adhesive-layer forming process P5 is overlapped with the quartz crystal substrate 40 having the other surface provided with the adhesive layers 32 and the electrodes 18 in the second-surface adhesive-layer and electrode forming process P8, such that the adhesive layers 32 face each other, and both of the adhesive layers 32 are bonded by atomic diffusion bonding. This procedure is substantially the same as that in the first-surface bonding process P7 and therefore will not be described. With the second-surface bonding process P9, the two quartz crystal wafers 34 and the quartz crystal substrate 40, in other words, the two holding layers 14 and the quartz crystal resonator layer 12, are bonded. FIG. 3H is a view for explaining a state in which, to the crystal substrate 40 bonded to the quartz crystal wafer 34 in the first-surface bonding process P7, the other quartz crystal wafer 34 is bonded on the other surface of the crystal substrate 40 in this second-surface bonding process P9. When the electrodes 18 disposed on both sides of the quartz crystal substrate 40 are disposed, the positions of the pair of the electrodes 18 sandwiching the quartz crystal substrate 40 are overlapped with each other.

In a cutting process P10, the individual load sensors 10 are cut from the pair of the quartz crystal wafers 34 and the quartz crystal substrate 40 bonded to each other. Specifically, for example, each of the load sensors 10 can be obtained by cutting with a dicing saw along cuts formed in the sandblast process P3.

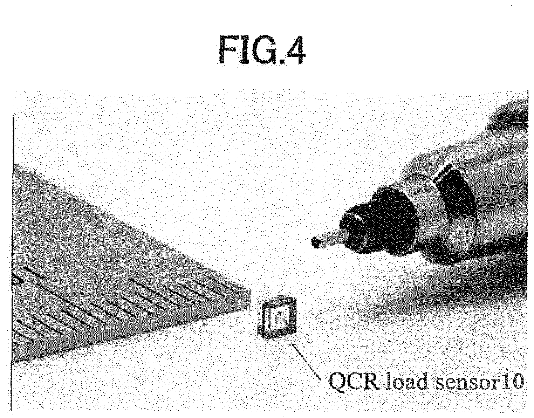

Fig. 4 is a photograph showing an appearance of the load sensor 10 actually produced with the above procedures by the inventors of the present invention. It is seen that the load sensor 10 having a size of 2 [mm] in length, 2 [mm] in width, and 1.04 [mm] in thickness is formed. To evaluate the oscillation characteristics of this load sensor, impedance characteristics were measured by using an impedance analyzer (ZA5405, NF circuit block). The circuit constants in an equivalent circuit of the quartz crystal resonator 16 estimated from the measured impedance characteristics are Ri=32.6 [Ω], Li=9.55 [mH], Ci=1.84 [fF], and $C_0$=0. 64 [fF], the resonance frequency is 37.881 [MHz], and the Q value is $6.9 \times 10^4$. It is seen that a favorable Q value is obtained. A direction of an arrow F of FIGS 1A and 1C indicates a direction in which a load is applied to the load sensor 10, i.e., a direction in which the load sensor 10 can detect a load.

Description will be made on a relationship between a measurement range of the load sensor using a quartz crystal resonator and the thickness of the quartz crystal resonator. The AT-cut quartz crystal resonator used as the quartz crystal resonator 16 in this example, i.e., the resonator cut out at an angle of 35 ° 15 ' from the z axis of synthetic quartz crystal, generates thickness-shear vibration and can provide a stable frequency signal when an oscillation circuit is attached. If an external force P [N] is applied to the quartz crystal resonator 16, the frequency varies in proportion to the magnitude of the external force. A frequency variation amount Δf [Hz] has a proportional relation as follows:
[Math. 1]

$$ \Delta f = S_S P \qquad (1) $$

where Ss is a sensor sensitivity and is represented by the following equation:
[Math. 2]

$$ S_S = \beta \frac{\eta}{wt^2} \qquad (2) $$

where β is a sensitivity coefficient determined by a direction of a stress to the quartz crystal, η is a load transfer efficiency, and w and t are the width and thickness of the quartz crystal resonator 16. From Eq. (2) above, it is understood that the sensor sensitivity Ss can effectively be improved by reducing the thickness t of the quartz crystal resonator 16. The load transfer efficiency η is defined as a ratio between the force applied to the load sensor 10 and the force actually applied to the quartz crystal resonator layer 12.

A practical resolution $P_{res}$ of the load sensor 10 is represented by Eq. (3) below using the sensor sensitivity Ss.
[Math. 3]

$$ P_{res} = \frac{f_F}{S_S} \qquad (3) $$

where $f_F$ is a frequency fluctuation range of sensor output and represents stability of oscillating frequency. On the other hand, a theoretical allowable load of the sensor is represented by Eq. (4) below:
[Math. 4]

$$ P_{max} = \frac{\sigma_{max} \cdot wt}{\eta} \qquad (4) $$

where $\sigma_{max}$ represents a maximum allowable stress of the sensor. It is understood that a maximum allowable load $P_{max}$ can be increased by reducing the load transfer efficiency η in Eq. (4) above.

Since a measurement range ρ of the load sensor 10 is represented by a ratio between the maximum allowable load $P_{max}$ and the practical resolution $P_{res}$, the theoretical measurement range ρ can be represented by Eq. (5) below from Eqs. (3) and (4) above.
[Math. 5]

$$ \rho = \frac{P_{max}}{P_{res}} = \frac{\beta \cdot \sigma_{max}}{f_F t} \qquad (5). $$

From Eq. (5), it is understood that methods usable for widening the measurement range ρ of the load sensor 10 may include (i) reducing the thickness t of the quartz crystal resonator 16, (ii) improving the stability of the sensor output, i.e., reducing the frequency fluctuation range $f_F$, (iii) increasing the maximum allowable load $P_{max}$, etc. Among these methods, the present invention aims to widen the measurement range of the load sensor 10 using the quartz crystal resonator 16 by reducing the thickness of the quartz crystal resonator 16 and aims to suppress the occurrence of bending or buckling of the quartz crystal resonator 16, which is a problem caused due to a reduction in thickness of the quartz crystal resonator 16.

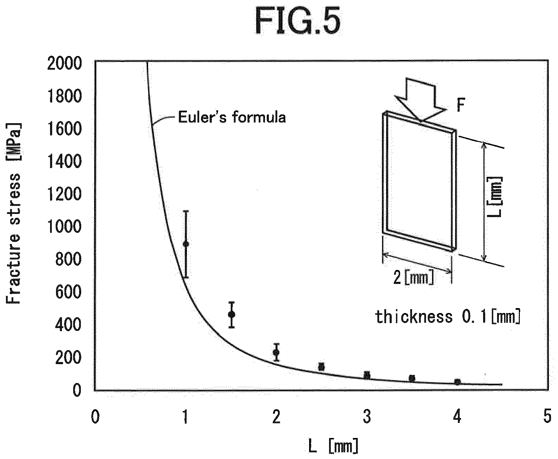

Quartz crystal is a crystal material with less crystal defects and therefore hardly causes dislocation and has excellent mechanical characteristics. Thus, quartz crystal has high strength against compressive stress. On the other hand, quartz crystal is a brittle material and therefore weak against tension and bending stress, and particularly, since the quartz crystal resonator 16 has a thin structure, the maximum allowable load of the load sensor using a quartz crystal resonator is determined considering a buckling load. In this regard, the inventors performed a fracture test on quartz crystal pieces different in length to examine a relationship between the length and the compressive load at the time of fracturing, and the results are as follows. In the experiment, test pieces having a thickness of 100 [μm], a width of 2 [mm], and a length L differentiated from 1 [mm] to 4 [mm] in increments of 0.5 [mm] were disposed on the load sensor, and the test pieces were compressed by applying a load until the test pieces fracture. As shown in Fig. 5, the direction of application of the load is a plane direction of a flat plate-shaped quartz crystal piece. This load application direction corresponds to a load application direction, i.e., a load detection direction, when the test piece made of quartz crystal is used for the quartz crystal resonator layer 12 of this example. The load at the time of fracturing was measured by using a load cell (9031A manufactured by Kistler Corporation). The results are plotted in Fig. 5. In Fig. 5, the horizontal axis and the vertical axis respectively indicate the length L of the test piece and a value obtained by converting the compressive load at the time of fracturing to a stress [MPa]. The standard deviations of the measurement results are represented by error bars.

Fig. 5 also shows a curve representative of a theoretical value of the buckling load. This curve corresponds to Eq. (6) below representing a buckling stress at a fixed end when both ends are freely rotatable. [Math. 6]

$$P_{cr} = \frac{\pi^2 El}{l^2} \quad (6).$$

Eq. (6) is obtained from Euler's formula. E is the Young's modulus of the test piece, I is the second moment of area in the test piece, and l is the length of the test piece.

As shown in Fig. 5, the stress causing the fracturing of quartz crystal becomes higher as the length of the test piece becomes shorter, and it is considered that the fracturing is caused due to the buckling stress. Additionally, although a fracture stress is about 900 [MPa] when the test piece has a length of 1 [mm], a tensile rupture stress of the test piece is about 150 [MPa], and therefore, the fracture stress is larger than the rupture stress. This suggests that the load sensor using a quartz crystal resonator provides a higher allowable stress as compared to a tensile rupture stress due to the structure preventing the buckling.

Subsequently, to confirm the effectiveness of the structure of the load sensor 10 of the present invention, a buckling load analysis was conducted by using SolidWorks Simulation (2014 SP 5.0, SolidWorks). From the analysis results, the buckling load of the vibrating portion of the quartz crystal resonator 16 was 996 [N], and the stress in the quartz crystal resonator 16 was 573 [MPa], On the other hand, the buckling load of the test piece having the same shape as the quartz crystal resonator 16 in this example of 2 [mm] in length, 2 [mm] in width, 41.7 [μm] in thickness is 4.5 [N], which is converted to a stress of 54 [MPa], and therefore, it is understood that the buckling stress is improved about 10 times. The maximum allowable load $P_{max}$ increases due to the improvement of the buckling stress, and it is understood from Eq. (5) above that the expansion of the measurement range $\rho$ can be expected.

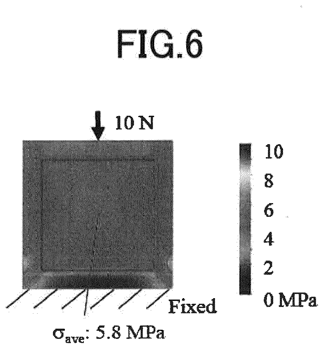

Furthermore, to obtain the load transfer efficiency $\eta$, the von Mises stress in the quartz crystal resonator 16 was analyzed when a load of 10 [N] was applied in the vertical direction from an upper end to the load sensor 10 with a lower end fixed, and the results are shown in Fig. 6. SolidWorks Simulation described above was used for analyzing the stress. From the analysis results, as shown in Fig. 6, it is seen that portions to which strong stress and weak stress are applied are generated in an upper end portion and a lower end portion, respectively, of the load sensor 10. Additionally, from the analysis results, the load applied to the quartz crystal resonator 16 was 0.48 [N] when the load of 10 [N] was applied. This is calculated from the fact that a central portion of the quartz crystal resonator 16 has a stress of 5.8 [MPa] and a cross section of 2.0 [mm] × 41.7 [μm]. Therefore, the theoretical load transfer efficiency $\eta$ was 4.8%. It is understood from Eq. (4) above that by lowering the load transfer efficiency $\eta$, the maximum allowable load $P_{max}$ may be increased even though the thin quartz crystal resonator 16 is used.

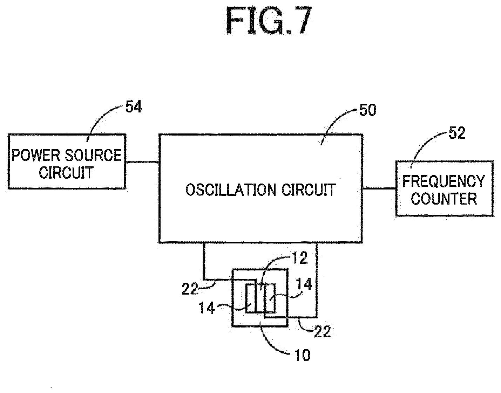

Subsequently, an experiment was conducted by actually applying a load to examine the load sensor 10 of this example in terms of load characteristics, and the results will be described. Fig. 7 is a diagram for explaining a general configuration of a load measurement system including the load sensor 10 of this example. The system is configured to include the load sensor 10, the oscillation circuit 50 for causing the quartz crystal resonator 16 serving as a main portion of the load sensor 10 to oscillate continuously, a frequency counter 52 for reading a frequency of a periodic signal output from the oscillation circuit 50, and a power source circuit 54 for supplying power to the oscillation circuit 50 etc. For the oscillation circuit 50, a general Colpitts type oscillation circuit was used as the oscillation circuit of the quartz crystal resonator 16. For the frequency counter 52, for example, 53230A manufactured by Agilent was used.

In the system configured in this way, a load application experiment was conducted. In the experiment, the load sensor 10 was placed in the posture shown in FIG. 1A vertically on the load cell (9031A, Kistler) disposed on a stage. A frame plate disposed at a fixed position outside the stage is disposed above the load sensor 10, so that an upper surface of the load sensor 10 comes into contact with the frame plate by raising the stage, and when the stage is further raised, a load is applied to the load sensor 10 downward from the upper side of the load sensor 10. To check the withstand load of the load sensor 10, the load was applied until fracturing of the load sensor 10 so as to measure load characteristics. The applied load and the output of the sensor were measured by the load cell and the frequency counter 52, respectively, so as to measure the variation amount $\Delta f$ of the output frequency relative to an applied load P of the load sensor 10.

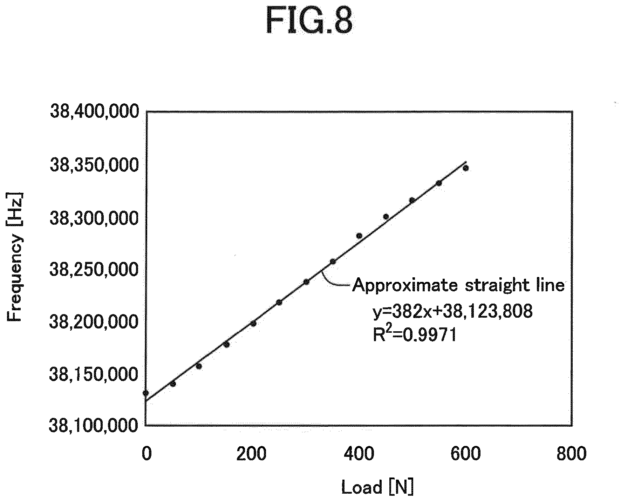

Fig. 8 is a diagram for explaining this measurement result. As a result of linear approximation of the experimental result plotted in Fig. 8, the relationship between the external load P (=x) [N] in the load sensor 10 and a resonance frequency Y [Hz] of the quartz crystal resonator 16 is linearly approximated by Eq. (7) below.

$$Y=382x+38123808 \qquad (7)$$

In this case, the correlation coefficient was $R^2=0.997$. From a gradient of an approximate straight line, the sensor sensitivity Ss is 382 [Hz/N].

It was confirmed by the load application experiment that the load sensor 10 of this example has the withstand load of 600 [N]. The stress in the quartz crystal resonator 16 at the time of fracturing is theoretically obtained as 345 [MPa] by using the load transfer efficiency $\eta$. This is a value exceeding 150 [MPa], which is a general fracture stress of quartz crystal, and it is understood that the load sensor 10 of this example was able to be improved in the maximum allowable load $P_{max}$ by the structure suppressing the buckling. On the other hand, according to the analysis result described above, the stress of the quartz crystal resonator 16 at the time of buckling is 573 [MPa], while the actual experimental result shows a lower value. In the load application experiment, the fracturing of the load sensor 10 was caused by a crack in a bonding surface (a portion of the adhesive layer 32) between the holding layer 14 and the quartz crystal resonator layer 12, and it is believed that by making an improvement such as more strongly bonding the bonding surface, the stress of the quartz crystal resonator 16 can be brought closer to the actual value of the analysis, i.e., higher allowable stress can be obtained.

Subsequently, an experiment was conducted for evaluating an output stability of the load sensor 10 of this example, i.e., a time stability of the sensor output, and the results will be described. In the experiment, after a sufficient time has elapsed after the load sensor 10 was placed at a constant temperature of 25 °C and a steady state was achieved, a time variation of the sensor output was measured. In other words, under the condition that the load applied to the load sensor 10 does not change, the output of the load sensor 10, i.e., the variation $\Delta f$ [Hz] of the oscillating frequency f of the quartz crystal resonator 16 was measured.

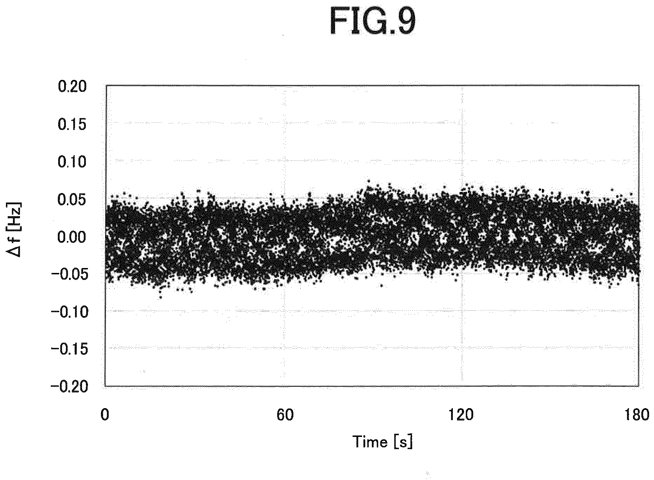

Fig. 9 is a diagram showing the result of this experiment. Measurement was performed for three minutes at a sampling frequency of 100 [Hz]. As a result, the frequency fluctuation $\Delta f$ is within 0.15 [Hz], and it was confirmed that the practical resolution is 0.4 [mN] in the three-minute measurement in terms of the sensitivity of the load sensor 10.

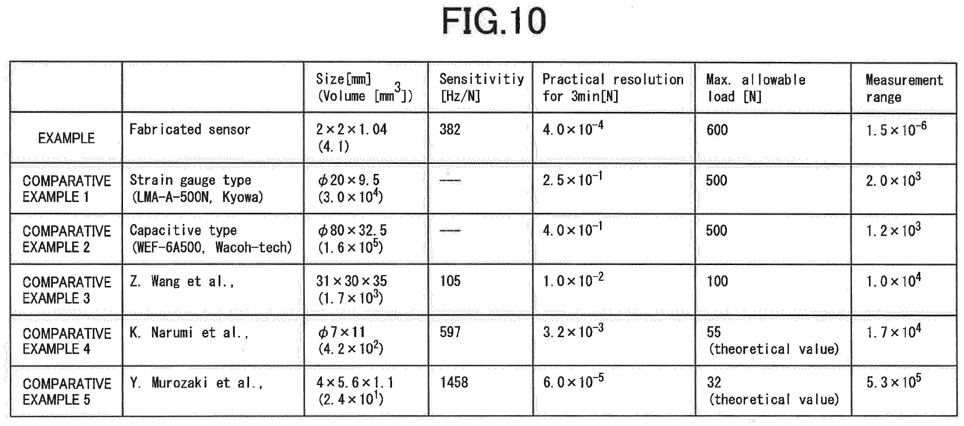

Fig. 10 is a diagram of comparison of the characteristics of the load sensor 10 of this example with conventional sensors, i.e., a load sensor using a strain gauge (Comparative Example 1), a capacitance type load sensor (Comparative Example 2), and load sensors having other configurations using quartz crystal resonators (Comparative Examples 3 to 5). For Comparative Example 1 and Comparative Example 2, LMA-A-500N manufactured by Kyowa and WEF-6A500 manufactured by Wacoh-tech, respectively, were used as general examples. Comparative Example 3 is described in Z. Wang et al., "A thickness-shear quartzforce sensor with dual-mode temperature and pressure", IEEE Sens. J., Vol. 3, No. 4, pp. 490-497, Aug. 2003, Comparative Example 4 is described in K. Narumi et al., "Miniaturization and resolution improvement of load sensor using AT-cut quartz crystal resonator", Proc. of IEEE/SICE International Symposium on System Integration 2009, pp. 13-18, Jan. 2009, and Comparative Example 5 is described in Y. Murozaki et al., "Wide range load sensor using Quartz Crystal Resonator for detection of biological signals" Sensors J., Vol. 15, pp. 1913-1919, 2015.

Comparing the load sensor 10 of this example with the Comparative Examples 1 to 5, it is understood that the load sensor 10 of this example has the wide measurement range $\rho$. Furthermore, even in comparison of the load sensor 10 with Comparative Examples 3 to 5 that are the conventional load sensors using quartz crystal resonators, it is understood that the load sensor 10 of this example has high sensor sensitivity relative to the maximum allowable load $P_{max}$. Particularly, it is understood that the measurement range of $4.0 \times 10^{-4}$ [N] to 600 [N], i.e., the measurement range of the order of magnitude of $10^6$, is achieved.

Furthermore, an application example of the load sensor 10 of this example will be described. Since the load sensor 10 of this example has a wide measurement range as described above, for example, an application can be implemented as described below.

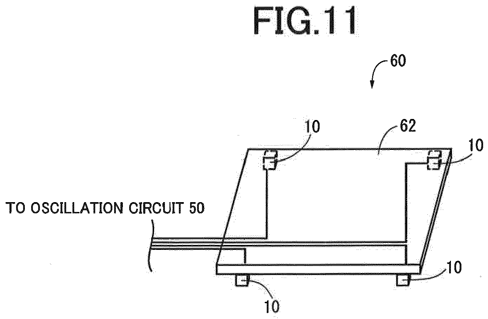

Fig. 11 is a diagram for explaining a measuring device 60 for simultaneously measuring a body weight and a pulse wave of a subject by using the load sensor 10 of this example. The measuring device 60 has, for example, a rigid plate 62 formed into a rectangular shape disposed on the four load sensors 10 positioned at the four corners of the plate 62. Each of the load sensors 10 has a fixed bottom surface, and the entire load applied to the plate 62 are shared by the four load sensors 10.

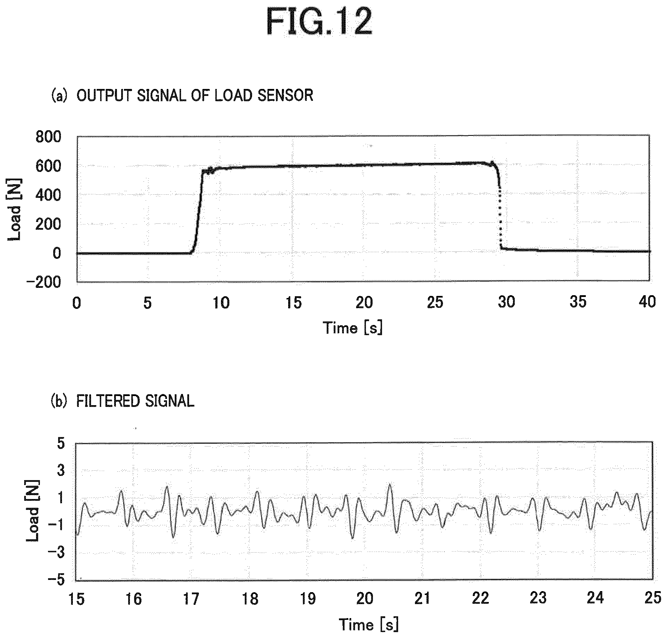

FIGS. 12A and 12B show a sum of outputs of the four load sensors 10, i.e., a resultant force of the four load sensors 10, in a case where a subject having a body weight of 62 [kg] rides on the plate 62. When the subject gets on the plate 62, a load change of about 610 [N] is detected. This is considered as correct detection of the body weight of the subject. Additionally, among signals acquired by applying a band pass filter having a passband of 0.6 [Hz] to 10 [Hz] to the obtained measurement result, the signals from 20 seconds to 25 seconds on the horizontal axis (time axis) of FIG. 12A are shown in FIG. 12B. The signals shown in FIG. 12B oscillate at substantially the same cycle as 65 [bpm] indicated by a pulse wave sensor (Surfing PO manufactured by Koike Medical) attached to a subject's finger. This indicates that the body weight and the pulse wave of the subject can be measured at the same time by the measuring device 60, which is achieved because the load sensor 10 of this example has the wide measurement range.

According to the example described above, the load sensor 10 detecting a magnitude of an external load applied in a direction parallel to a sheet shape of the sheet-shaped quartz crystal resonator 16 comprises the quartz crystal resonator layer 12 including the sheet-shaped quartz crystal resonator 16 and the pair of the electrode portions 18 on a pair of surfaces of the quartz crystal resonator 16 opposite to each other in the plate thickness direction of the quartz crystal resonator 16, and at least one of the holding layers 14 causing a displacement in substantially the same amount as the quartz crystal resonator layer 12 when an external load is applied to the quartz crystal resonator layer 12, and therefore, even if a bending stress is generated in the quartz crystal resonator 16 in a case where the external load is applied in the direction parallel to the sheet shape of the sheet-shaped quartz crystal resonator 16, deformation of the quartz crystal resonator 16 in the bending direction is suppressed by the at least one holding layer 14, so that buckling of the quartz crystal resonator 16 can be prevented. Additionally, when the external load is applied to the quartz crystal resonator 16, the quartz crystal resonator layer 12 and the holding layer 14 causes displacements in substantially the same amount, so that a force is prevented from occurring in the bending direction due to a difference in displacement of the both layers 12 and 14. Therefore, the thickness of the sheet-shaped quartz crystal resonator 16 can be reduced, and the measurement range can be widened.

According to the example described above, the holding layers 14 are a pair of holding layers disposed to sandwich both sides of the sheet shape of the quartz crystal resonator layer 12 and causing a displacement in substantially the same amount as the quartz crystal resonator layer 12 when the external load is applied to the quartz crystal resonator layer 12, and therefore, the quartz crystal resonator layer 12 is restrained from deforming toward both sides of the sheet shape, so that the buckling of the quartz crystal resonator layer 12 can further be suppressed.

According to the example described above, since the holding layers 14 are bonded to the quartz crystal resonator layer 12 via the adhesive layers 32, the quartz crystal resonator layer 12 and the holding layers 14 are bonded by the adhesive layers 32, so that the buckling of the quartz crystal resonator layer 12 can be suppressed.

According to the example described above, since the holding layer 14 is made of quartz crystal, and the holding layers 14 and the quartz crystal resonator layer 12 are bonded by atomic diffusion bonding of the adhesive layers 32 respectively disposed thereon, the holding layers 14 and the quartz crystal resonator layer 12 can perform like an integrated crystal, so that the buckling of the quartz crystal resonator layer 12 can be suppressed.

According to the example described above, since the holding layers 14 and the quartz crystal resonator layer 12 are made of materials having substantially equivalent rates of thermal expansion, the holding layers 14 and the quartz crystal resonator layer 12 have common thermal expansion characteristics regardless of an environmental temperature at which the load sensor 10 is placed, so that it is not necessary to give consideration to a difference in expansion amount of these layers 14 and 12 in the measurement result depending on the environmental temperature.

Other examples of the present invention will then be described. In the following description, portions common to the examples are denoted by the same reference numerals and will not be described.

Second Example

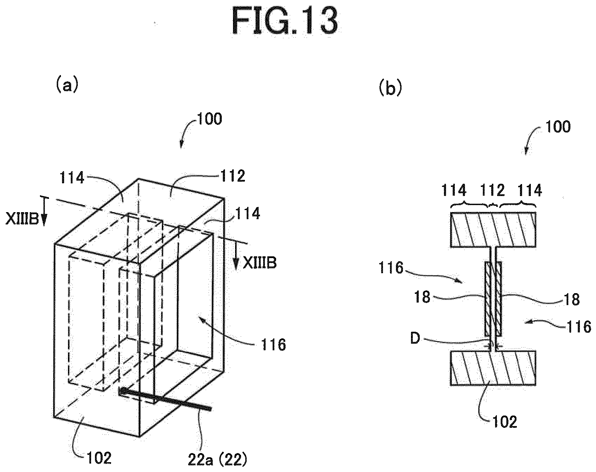

FIGS. 13A and 13B are diagrams for explaining a load sensor 100 according to another example of the present invention. FIG. 13A is a perspective view of the load sensor 100, and FIG. 13B is a cross-sectional view taken along XIIIB-XIIIB of FIG. 13A.

The load sensor 100 of this example is obtained by removing (hollowing out) respective cavities 116 to the inside from a pair of opposite surfaces of one block-shaped quartz crystal 102 having a rectangular parallelepiped shape, for example. The respective cavities 116 are removed toward the center from the left and right in FIG. 13B such that the quartz crystal remains in a wall shape having a predetermined thickness D in a central portion. The wall-shaped quartz crystal having this thickness D serves as a quartz crystal resonator layer 112 in the load sensor 100 and corresponds to the quartz crystal resonator layer 12 in the load sensor 10 of the example described above. Portions of the quartz crystal 102 other than the quartz crystal resonator layer 112, i.e., paired tubular portions provided with the cavities 116, are holding layers 114 of the load sensor 100 and correspond to the holding layers 14 of the load sensor 10 of the example described above.

The quartz crystal resonator layer 112 is provided with the same electrodes 18 as in the example described above on both sides of the wall shaped surface and is provided with the electric wires 20, 22 for connecting the electrodes 18 and the oscillation circuit 50. Unlike the example described above, the holding portions 114 have the cavities 116 communicating with the outside, so that the electric wires 22 may be led out through the cavities 116 to the outside of the load sensor 100. In FIG. 13A, the electrodes 18 etc. are not shown.

According to the load sensor 100 of this example, since the holding layers 114 and the quartz crystal resonator layer 112 are originally one block-shaped crystal 102, each of the layers 114 and 112 is not a separated layer, and therefore, the adhesive layer 32 is not required for bonding these layers 114 and 112 as in the previous example. The quartz crystal resonator layer 112 is sandwiched between the holding layers 114 on both sides of the plane shape thereof, and the quartz crystal resonator layer 112 and the holding layers 114 are integrally made of the single quartz crystal 102, so that the buckling of the quartz crystal resonator layer 112 can be suppressed when a load is applied to the quartz crystal resonator layer 112 in a direction perpendicular to the thickness direction thereof. Third Example

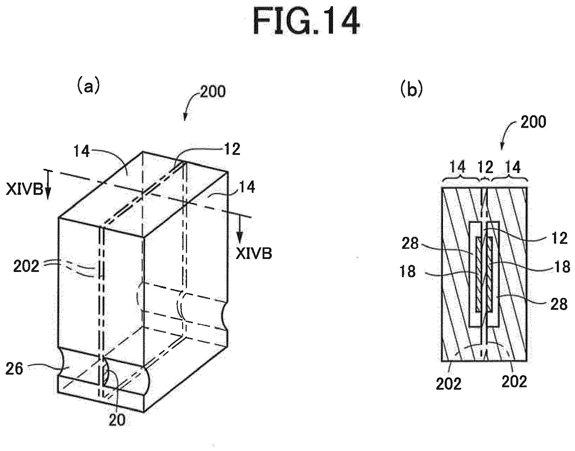

FIGS. 14A and 14B are diagrams for explaining a load sensor 200 according to yet another example of the present invention. FIG. 14A is a perspective view of the load sensor 200, and FIG. 14B is a cross-sectional view taken along XIVB-XIVB of FIG. 14A.

The load sensor 200 is the same as the load sensor 10 of the example described above in that the load sensor 200 is configured to include the quartz crystal resonator layer 12 and a pair of the holding layers 14 each made of quartz crustal. Additionally, the quartz crystal resonator layer 12 is provided with the electrodes 18, the electric wires 20, 22, etc., and the holding layers 14 are provided with the recesses 28 in the same way. On the other hand, the load sensor 200 is different from the load sensor 10 in that the adhesive layers 32 are not disposed for bonding the quartz crystal resonator layer 12 and the pair of the holding layers 14. In FIG. 14A, the electrodes 18 etc. are not shown.

In this example, the quartz crystal resonator layer 12 and the pair of the holding layers 14 are all made of quartz crystal and are caused to react such that the layers 12 and 14 are directly bonded each other at bonding surfaces 202. As a result, the quartz crystals constituting the quartz crystal resonator layer 12 and the pair of the holding layers 14 prepared separately are directly bonded at the bonding surfaces 202, i.e., molecularly bonded to each other, into a configuration like one quartz crystal.

According to the load sensor 200 of this example, since the quartz crystal resonator layer 12 and the pair of the holding layers 14 are molecularly bonded at the bonding surfaces 202, the quartz crystal resonator layer 12 and the pair of the holding layers 14 can be bonded without disposing the adhesive layers 32 and perform like an integrated crystal, so that the buckling of the quartz crystal resonator layer 12 can be suppressed when a load is applied to the quartz crystal resonator layer 112 in a direction perpendicular to the thickness direction thereof.

Although the examples of the present invention have been described in detail with reference to the drawings, the present invention is also applicable in other forms outlined in the appended claims.

For example, in the example described above, the pairs of the holding layers 14, 114 are disposed to sandwich the sheet-shaped quartz crystal resonator layers 12, 112 from both sides; however, the present invention is not limited to this configuration. Specifically, when the holding layers 14, 114 are disposed on at least one surface of the sheet-shaped quartz crystal resonator layers 12, 112, a certain effect is produced.

In the example described above, the quartz crystal resonator 16 has a square shape with a size of 2 mm in the longitudinal and lateral directions; however, the present invention is not limited to this form. For example, to increase a load stress to quartz crystal relative to an applied load to achieve an improvement in sensitivity by reducing a cross section of the quartz crystal resonator 16 as viewed in a load application direction, the quartz crystal resonator 16 may have the length in the longitudinal direction L, i.e., the length in the load application direction, made longer than the length in the direction perpendicular to the load application direction.

In the example described above, the electrodes 18 and the electric wires 20 are disposed by sputtering as pattern wirings, respectively; however, the present invention is not limited to such a form. For example, both the electrodes 18 and the electric wires 20 may be formed on the quartz crystal resonator 16 by sputtering and, in this case, in other words, the electrodes 18 and the electric wires 20 may be provided without distinction. Alternatively, the electric wires 22 may not be provided, and the electric wires 20 may each directly be led out to the outside of the load sensor 10.

In the example described above, the shape of the electrodes 18 is a circular shape; however, the present invention is not limited thereto, and other shapes may be used.

In the example described above, wet etching is performed in the etching process P4, and sandblasting is performed in the sandblast process P3; however, the present invention is not limited thereto, and sandblasting may be performed instead of etching, and/or etching may be performed instead of sandblasting. For the method of etching, reactive ion etching (RIE) or wet etching may be used instead.

In the example described above, after the adhesive layer 32 and the electrode 18 are disposed on the first surface of the quartz crystal substrate 40 in the first-surface adhesive-layer and electrode forming process P6, and the first-surface bonding process P7 is performed to bond the first surface of the quartz crystal substrate 40 and the quartz crystal wafer 34, the adhesive layer 32 and the electrode 18 are disposed on the second surface of the quartz crystal substrate 40 in the second-surface adhesive-layer and electrode forming process P8, and the second-surface bonding process P9 is performed to bond the second surface of the quartz crystal substrate 40 and the quartz crystal wafer 34; however, the present invention is not limited to this form. Therefore, after the adhesive layer 32 and the electrode 18 are disposed on the first surface of the quartz crystal substrate 40 in the first-surface adhesive-layer and electrode forming process P6, and subsequently, the adhesive layer 32 and the electrode 18 are disposed on the second surface of the quartz crystal substrate 40 in the second-surface adhesive-layer and electrode forming process P8, the first-surface bonding process P7 may be performed to bond the first surface of the quartz crystal substrate 40 and the quartz crystal wafer 34, and the second-surface bonding process P9 may further be performed to bond the second surface of the quartz crystal substrate 40 and the quartz crystal wafer 34.

Although the dicing saw is used in the cutting process P10 in the example described above, the present invention is not limited thereto and, for example, a cutter using laser light may be used.

In the example described above, the Cr/Ag thin films are respectively disposed as the adhesive layers 32 on the quartz crystal resonator layer 12 and the holding layers 14 and are bonded by atomic diffusion bonding; however, the present invention is not limited thereto, and an adhesive may be used. In this case, although the adhesive layers 32 are disposed except the electric wire 20 and a certain vicinity thereof as in the example described above, such disposition is not required if the adhesive has insulation properties. For example, the adhesive layers 32 may be disposed on the entire surfaces other than the electrodes 18 to cover the electric wires 20. If the quartz crystal resonator layer 12 and the holding layers 14 are directly bonded as in the third example, the adhesive layers 32 are not required.

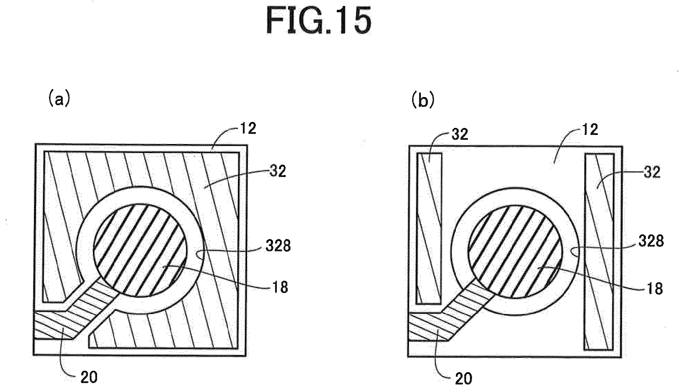

In the example described above, the adhesive layers 32 have a shape surrounding the outer circumferential side on the surfaces of the quartz crystal resonator 16; however, the present invention is not limited thereto. For example, the adhesive layers 32 may have an annular shape along an outer edge of the step 28, or may be disposed as shown in FIG. 15A on the entire surface of the quartz crystal resonator layer 12 except the electrode 18, the electric wire 20, and a portion within a certain distance therefrom, or may have an elongated shape as shown in FIG. 15B extending in the load application direction, i.e., in the vertical direction of FIG. 15B. A partially-cut circle 328 of FIGS. 15A and 15B is a line for explaining the size and the position of the step 28 disposed in the holding layer 14 to be affixed to the quartz crystal resonator layer 12. Since the adhesive layer 32 includes at least a longitudinal shape extending in the load application direction, an effect of suppressing the buckling can be produced when a load is applied to the quartz crystal resonator layer 12.

The above description is merely an embodiment and the present invention can be implemented in variously modified and improved forms based on the knowledge of those skilled in the art.

INDUSTRIAL APPLICABILITY

The load sensor of the present invention has both a wide measurement range and a high resolution and therefore may be utilized in implementation to "casual sensing" for capturing bionomical information unconsciously with measuring devices disposed in environment such as rooms, belongings, and clothes continuously, without the need of specially mounting a sensor device for measurement.

REFERENCE SIGNS LIST

10, 100, 200: load sensor 12, 112: quartz crystal resonator layer 14, 114: holding layer 16: quartz crystal resonator 18: electrode 20: electric wire 28: step 32: adhesive layer 102: quartz crystal 116: cavity 202: bonding surface

## Claims

1. A load sensor (10; 200) detecting a magnitude of an external load applied in a direction parallel to a plane direction of a sheet-shaped quartz crystal resonator (16), the load sensor comprising:

   a quartz crystal resonator layer (12) including the sheet-shaped quartz crystal resonator (16) and a pair of electrode portions (18) on a pair of surfaces opposite to each other in a thickness direction of the sheet-shaped quartz crystal resonator (16); and
   a pair of holding layers (14) disposed to sandwich both sides of the quartz crystal resonator layer (12) in the thickness direction and causing a displacement in substantially the same amount as the quartz crystal resonator layer (12) when the external load is applied to the quartz crystal resonator layer (12), wherein
   the holding layers (14) and the quartz crystal resonator layer (12) are made of materials having substantially equivalent rates of thermal expansion, and
   **characterized in that**
   the pair of holding layers (14) overlaps the pair of electrode portions (18) in the thickness direction and recesses (28) are formed in the pair of holding layers (14) at portions corresponding to the pair of electrode portions (18).

2. The load sensor (10) according to claim 1, wherein the holding layers (14) are bonded to the quartz crystal resonator layer (12) via adhesive layers (32).

3. The load sensor (10) according to claim 2, wherein the adhesive layers have at least an elongated shape extending in an application direction of the external load.

4. The load sensor (10) according to claim 2 or 3, wherein each of the adhesive layers bonds the respective one of holding layers (14) and the quartz crystal resonator layer (12) through atomic diffusion bonding.

5. The load sensor (200) according to claim 1, wherein the holding layers (14) are made of quartz crystal material, and wherein the holding layers and the quartz crystal resonator layer (12) are coupled by direct bonding.

**Patentansprüche**

1. Lastsensor (10; 200), der eine Größe einer externen Last erfasst, die in einer Richtung anliegt, die zu einer Ebenenrichtung eines plattenförmigen Quarzkristallresonators (16) parallel ist, wobei der Lastsensor aufweist:

   eine Quarzkristallresonatorschicht (12), die den plattenförmigen Quarzkristallresonator (16) und ein Paar Elektrodenabschnitte (18) auf einem Paar von Oberflächen beinhaltet, die einander in einer Dickenrichtung des plattenförmigen Quarzkristallresonators (16) gegenüberliegen; und

   ein Paar Halteschichten (14), die so angeordnet sind, dass sie beide Seiten der Quarzkristallresonatorschicht (12) in der Dickenrichtung sandwichartig umgeben und eine Verschiebung in im Wesentlichen demselben Ausmaß wie die Quarzkristallresonatorschicht (12) verursachen, wenn die externe Last auf den Quarzkristallresonatorschicht (12) einwirkt, wobei die Halteschichten (14) und die Quarzkristallresonatorschicht (12) aus Materialien bestehen, die im Wesentlichen gleichwertige thermale Expansionsraten aufweisen, und **dadurch gekennzeichnet, dass** das Paar Halteschichten (14) das Paar Elektrodenabschnitte (18) in der Dickenrichtung überlappt und Vertiefungen (28) in dem Paar Halteschichten (14) an Abschnitten ausgebildet sind, die dem Paar Elektrodenabschnitte (18) entsprechen.

2. Lastsensor (10) nach Anspruch 1, wobei die Halteschichten (14) über Adhäsivschichten (32) mit der Quarzkristallresonatorschicht (12) verbunden sind.

3. Lastsensor (10) nach Anspruch 2, wobei die Adhäsivschichten zumindest eine längliche Form aufweisen, die in einer Einwirkungsrichtung der externen Last verlaufen.

4. Lastsensor (10) nach Anspruch 2 oder 3, wobei jede der Adhäsivschichten die entsprechende von den Halteschichten (14) und die Quarzkristallresonatorschicht (12) durch atomares Diffusionsbonden verbindet.

5. Lastsensor (200) nach Anspruch 1, wobei die Halteschichten (14) aus Quarzkristallmaterial bestehen, und wobei die Halteschichten und die Quarzkristallresonatorschicht (12) durch Direktbonden verbunden sind.

**Revendications**

1. Capteur de charge (10 ; 200) détectant l'ampleur d'une charge externe appliquée dans une direction parallèle à la direction de plan d'un résonateur à quartz en forme de feuille (16), le capteur de charge comprenant :

   une couche de résonateur à quartz (12) comprenant le résonateur à quartz en forme de feuille (16) et une paire de parties d'électrodes (18) sur une paire de surfaces opposées l'une à l'autre dans une direction d'épaisseur du résonateur à quartz en forme de feuille (16) ; et une paire de couches de maintien (14) disposées pour prendre en sandwich les deux côtés de la couche de résonateur à quartz (12) dans la direction d'épaisseur et provoquant un déplacement sensiblement identique à celui de la couche de résonateur à quartz (12) lorsque la charge externe est appliquée à la couche de résonateur à quartz (12), dans lequel les couches de maintien (14) et la couche de résonateur à quartz (12) sont constituées de matériaux ayant des taux de dilatation thermique sensiblement équivalents, et **caractérisé en ce que** la paire de couches de maintien (14) recouvre la paire de parties d'électrodes (18) dans la direction d'épaisseur et des évidements (28) sont formés dans la paire de couches de maintien (14) à des parties correspondant à la paire de parties d'électrodes (18).

2. Capteur de charge (10) selon la revendication 1, dans lequel les couches de maintien (14) sont liées à la couche de résonateur à quartz (12) par des couches adhésives (32).

3. Capteur de charge (10) selon la revendication 2, dans lequel les couches adhésives ont au moins une forme allongée s'étendant dans une direction d'application de la charge externe.

4. Capteur de charge (10) selon la revendication 2 ou 3, dans lequel chacune des couches adhésives relie la couche respective parmi les couches de maintien (14) et la couche de résonateur à quartz (12) par une liaison par diffusion atomique.

5. Capteur de charge (200) selon la revendication 1, dans lequel les couches de maintien (14) sont en cristal de quartz, et dans lequel les couches de maintien et la couche de résonateur à quartz (12) sont couplées par une liaison directe.

# FIG.1

(a)

(b)

(c)

# FIG.2

```
┌─────────────────────────────────┐ ⌐P1
│   FIRST PATTERNING PROCESS      │
└─────────────────────────────────┘
                │
┌─────────────────────────────────┐ ⌐P2
│  SECOND PATTERNING PROCESS      │
└─────────────────────────────────┘
                │
┌─────────────────────────────────┐ ⌐P3
│     SANDBLAST PROCESS           │
└─────────────────────────────────┘
                │
┌─────────────────────────────────┐ ⌐P4
│     ETCHING PROCESS             │
└─────────────────────────────────┘
                │                          ┌────────────────────────────────┐ ⌐P6
┌─────────────────────────────────┐ ⌐P5   │  FIRST-SURFACE ADHESIVE-LAYER  │
│ ADHESIVE-LAYER FORMING PROCESS  │       │ AND ELECTRODE FORMING PROCESS  │
└─────────────────────────────────┘       └────────────────────────────────┘
                │                                        │
                └──────────┐        ┌────────────────────┘
                           ▼        ▼
                ┌─────────────────────────────────┐ ⌐P7
                │  FIRST-SURFACE BONDING PROCESS  │
                └─────────────────────────────────┘
                           │
                ┌─────────────────────────────────┐ ⌐P8
                │ SECOND-SURFACE ADHESIVE-LAYER   │
                │ AND ELECTRODE FORMING PROCESS   │
                └─────────────────────────────────┘
                           │
        ┌──────────────────┤
        ▼                  ▼
                ┌─────────────────────────────────┐ ⌐P9
                │ SECOND-SURFACE BONDING PROCESS  │
                └─────────────────────────────────┘
                           │
                ┌─────────────────────────────────┐ ⌐P10
                │        CUTTING PROCESS          │
                └─────────────────────────────────┘
```

# FIG.3

(a) AFTER FIRST PATTERNING PROCESS

(b) AFTER SECOND PATTERNING PROCESS

(c) AFTER SANDBLAST PROCESS

(d) AFTER ETCHING PROCESS

(e) AFTER ADHESIVE-LAYER FORMING PROCESS

(f) AFTER FIRST-SURFACE ADHESIVE-LAYER AND
ELECTRODE FORMING PROCESS

(g) AFTER FIRST-SURFACE BONDING PROCESS

(h) AFTER SECOND-SURFACE BONDING PROCESS

# FIG.4

QCR load sensor10

# FIG.5

# FIG.6

10 N

10
8
6
4
2
0 MPa

Fixed

$\sigma_{ave}$: 5.8 MPa

# FIG.7

POWER SOURCE CIRCUIT 54

OSCILLATION CIRCUIT 50

FREQUENCY COUNTER 52

12
14
22
14
22
10

# FIG.8

# FIG.9

# FIG.10

| | | Size[mm] (Volume $[mm^3]$) | Sensitivitiy [Hz/N] | Practical resolution for 3min[N] | Max. allowable load [N] | Measurement range |
|---|---|---|---|---|---|---|
| EXAMPLE | Fabricated sensor | 2×2×1.04 (4.1) | 382 | $4.0×10^{-4}$ | 600 | $1.5×10^{-6}$ |
| COMPARATIVE EXAMPLE 1 | Strain gauge type (LMA-A-500N, Kyowa) | $\phi$20×9.5 $(3.0×10^4)$ | —— | $2.5×10^{-1}$ | 500 | $2.0×10^3$ |
| COMPARATIVE EXAMPLE 2 | Capacitive type (WEF-6A500, Wacoh-tech) | $\phi$80×32.5 $(1.6×10^5)$ | —— | $4.0×10^{-1}$ | 500 | $1.2×10^3$ |
| COMPARATIVE EXAMPLE 3 | Z. Wang et al., | 31×30×35 $(1.7×10^3)$ | 105 | $1.0×10^{-2}$ | 100 | $1.0×10^4$ |
| COMPARATIVE EXAMPLE 4 | K. Narumi et al., | $\phi$7×11 $(4.2×10^2)$ | 597 | $3.2×10^{-3}$ | 55 (theoretical value) | $1.7×10^4$ |
| COMPARATIVE EXAMPLE 5 | Y. Murozaki et al., | 4×5.6×1.1 $(2.4×10^1)$ | 1458 | $6.0×10^{-5}$ | 32 (theoretical value) | $5.3×10^5$ |

# FIG.11

# FIG.12

(a) OUTPUT SIGNAL OF LOAD SENSOR

(b) FILTERED SIGNAL

# FIG.13

(a)

(b)

# FIG.14

(a)

(b)

# FIG.15

(a)

(b)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015025796 A
- US 3479539 A
- US 20020078762 A1

**Non-patent literature cited in the description**

- **Z. WANG et al.** A thickness-shear quartz force sensor with dual-mode temperature and pressure. *IEEE Sens. J.,* August 2003, vol. 3 (4), 490-497
- **K. NARUMI et al.** Miniaturization and resolution improvement of load sensor using AT-cut quartz crystal resonator. *Proc. of IEEE/SICE International Symposium on System Integration 2009,* January 2009, 13-18
- **Y. MUROZAKI et al.** Wide range load sensor using Quartz Crystal Resonator for detection of biological signals. *Sensors J.,* 2015, vol. 15, 1913-1919